Europäisches Patentamt

European Patent Office

Office européen des brevets

(11) Publication number: **0 126 502**
**A2**

# EUROPEAN PATENT APPLICATION

(21) Application number: 84200550.6

(51) Int. Cl.³: **C 30 B 19/06**

(22) Date of filing: **18.04.84**

(30) Priority: **27.04.83 GB 8311428**

(43) Date of publication of application: **28.11.84**
Bulletin 84/48

(84) Designated Contracting States: **DE FR GB IT NL**

(71) Applicant: **PHILIPS ELECTRONIC AND ASSOCIATED
INDUSTRIES LIMITED, Arundel Great Court 8 Arundel
Street, London WC2R 3DT (GB)**

(84) Designated Contracting States: **GB**

(71) Applicant: **N.V. Philips' Gloeilampenfabrieken,
Groenewoudseweg 1, NL-5621 BA Eindhoven (NL)**

(84) Designated Contracting States: **DE FR IT NL**

(72) Inventor: **Brice, John Chadwick, c/o PHILIPS
RESEARCH LABORATORIES, Redhill Surrey RH1 5HA
(GB)**
Inventor: **Page, John Lincoln, c/o PHILIPS RESEARCH
LABORATORIES, Redhill Surrey RH1 5HA (GB)**

(74) Representative: **Boxall, Robin John et al, Philips
Electronic and Associated Ind. Ltd. Patent Department
Mullard House Torrington Place, London WC1E 7HD
(GB)**

(54) **Liquid phase epitaxy apparatus.**

(57) A sliding boat liquid phase epitaxy apparatus comprising a base 1, substrate support means 2 superposed on the base 1, and a well member 5 abutting and disposed above the substrate support means 2 and having at least one well 22 capable of containing growth solution 28. The substrate support means 2 comprise a recessed substrate holder 16 which can be disposed under and in registration with the well 22. The well member 5 and the substrate support means 2 are relatively slidable in the length direction of the apparatus. A problem encountered in growing layers of material by a liquid phase epitaxy process using a sliding boat apparatus is to achieve adequate wipe-off of growth solution in order to provide a grown layer having a smooth surface. The bottom of the well member 5 is provided with a plurality of grooves 23 on the side of the/each well which traverses or is traversed by the recessed substrate holder 16 after growth of an epitaxial layer, and wherein the grooves 23 extend across at least a width of the well member 5 which is greater than and includes the width of the substrate holder recess 16.

# LIQUID PHASE EPITAXY APPARATUS

The invention relates to a sliding boat apparatus suitable for use for the growth of layers by liquid phase epitaxy.

Sliding boat apparatus has been widely used for the growth by liquid epitaxy of layers of semiconductor materials such as II-VI and III-V alloys and compounds. A significant problem in all these processes has been the imperfections present in the surface of the layer resulting from incomplete separation of the growth solution from the grown layer at the termination of growth.

If good wipe-off is to be achieved, the substrate must be a good fit in the substrate holder which is used. The amount of material wiped off the grown layer by the well edge is usually insufficient to remove all the drops from the grown layer which have sprung back onto the grown layer during relative movement between the well member and the substrate holder. When the solution wets the substrate and the apparatus material, any drops of solution not removed by the wiping-off process can easily be squeezed into the space between the well member and the substrate and its holder. Drops which have been squeezed to cover a large area can exert vertical forces which are sufficiently large to lift the well member, permitting other drops or liquid solution in the gaps between the substrate and its holder to spring back onto the grown layer.

An object of the invention is to provide an apparatus with an improved wiping-off characteristic.

The invention provides a sliding boat liquid phase epitaxy apparatus comprising a base, substrate support means superposed on the base, and a well member abutting and disposed above the substrate support means and having at least one well capable of containing growth solution, the substrate support means comprising a recessed substrate holder which can be disposed under the/each well, wherein the well member and the substrate support means are relatively slidable in the length direction of the apparatus, wherein the bottom of the well member is provided with a plurality of grooves on the side of the/each well which traverses or is traversed by the recessed substrate holder after growth of an epitaxial layer, and wherein the grooves extend across at least a width of the well member which is greater than and includes the width of the substrate holder recess. By providing the grooves on the bottom of the well member, a plurality of edges sweep over and above the grown layer, and this results in drops of solution present on the grown layer after the layer has been traversed by the edge of the well, being swept into and retained in these grooves. Preferably the grooves are straight, and extend across the width of the well member, since such grooves are the easiest to produce. However, the grooves may, for example, have longitudinal axes which are V-shaped, curved or arcuate. Satisfactory results have been obtained with arcuate grooves having a radius of curvature which is larger than the diameter of the associated well. When grooves which are not straight are used, preferably the first part of the groove to cross the substrate should be near the longitudinal axis of the sliding boat apparatus.

In one embodiment of the invention, the well member is fixed in a horizontal sense with respect to the base, and the substrate support means are then a slide restricted in operation to longitudinal movement in the apparatus and having a recessed substrate holder. In this embodiment, the well member may be held rigidly in a vertical direction with respect to the base.

The apparatus may comprise means for lifting a substrate out of the substrate holder, the means comprising a plunger which is slidable in a bore extending from the bottom of the slide into the substrate holder, the bottom of the plunger being at least partly bevelled, further means for maintaining this bevelled surface substantially parallel to a ramp formed in the upper surface of the base, wherein the bevelled surface of the plunger co-operates with the ramp so as to lift the plunger so that it abuts and then lifts a substrate disposed in the substrate holder out of the substrate holder after the completion of epitaxial growth and before growth solution in contact with the substrate holder has frozen. The ramp may, for example, be at one end of a groove extending longitudinally in the upper surface of the base.        The further means may consist of the co-operating non-circular cross-sections of the plunger and of the bore. The further means may comprise faces on opposite sides of a lower portion of the plunger which are parallel to the longitudinal axis of the apparatus and which co-operate with the sides of a groove extending longitudinally in the upper surface of the base.

The substrate support means may be fixed in a horizontal sense with respect to the base, and the well member is then slidable over the substrate support means in the length direction of the apparatus.

In order to reduce the risk of growth solution being drawn by capillary forces into the recesses between a substrate and the side walls of the recessed substrate holder, it is preferred that the area of the/each well should be smaller than the area of the substrate holder recess.

Two embodiments of the invention will now be described with reference to the following Examples and to the accompanying drawings, in which:-

Figure 1 is a cross-sectional view of a sliding boat apparatus taken on a line I-I in Figure 2 viewed in the direction of the arrows,

Figure 2 is a longitudinal section of the apparatus shown in Figure 1,

Figure 3 is a plan view of a slide which is part of the apparatus shown in Figures 1 and 2,

Figure 4 is a cross-section of another sliding boat apparatus taken on a line IV-IV in Figure 5 viewed in the direction of the arrows, and

Figure 5 is a longitudinal section of the apparatus shown in Figure 4,

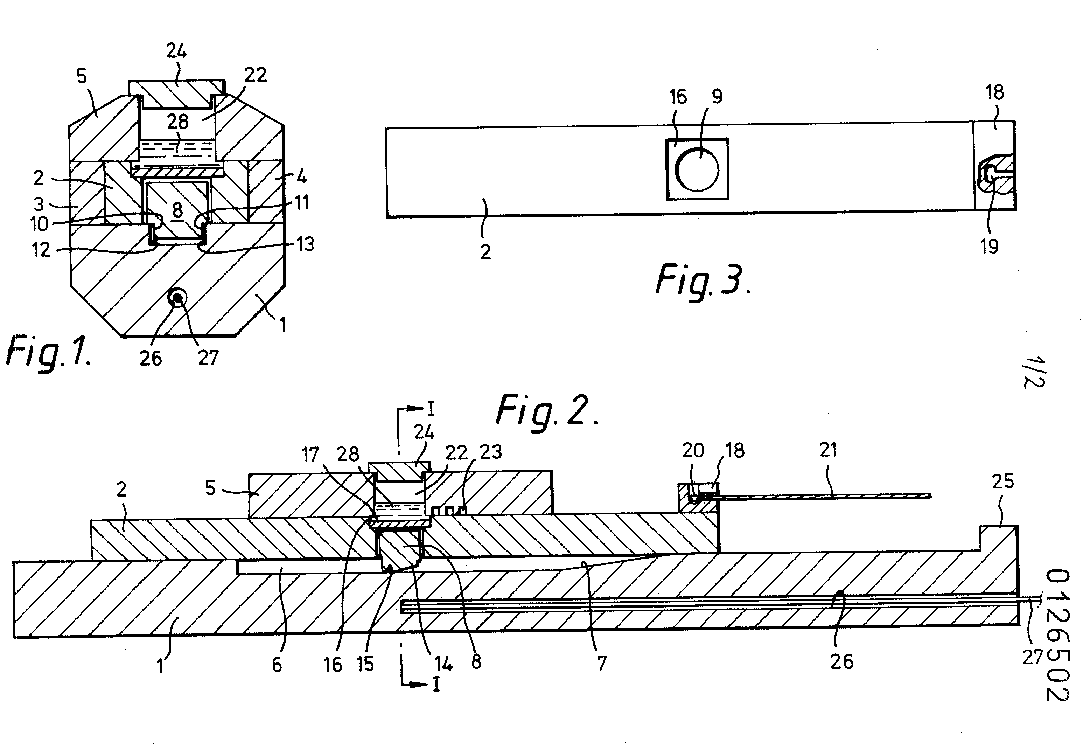

For the sake of clarity, Figure 1 is drawn on a larger scale than Figures 2 and 3.

EXAMPLE 1

Referring to Figure 1, a sliding boat apparatus made of graphite and used for growing layers of material by liquid phase epitaxy comprises a base 1 upon which a slide 2 is located between two parallel spacing members 3, 4 which are fixed to the base 1. A well member 5 is secured to the spacing members 3, 4 and thus the slide 2 can only move longitudinally in the apparatus, and the well member 5 is held rigidly in a vertical direction as well as in a horizontal direction with respect to the base 1.

The base 1 is provided with a longitudinally extending groove 6 in its upper surface, this groove 6 having a rectangular cross-section and terminating at its right hand end (Figure 2) in a ramp 7 which is inclined at an angle of approximately $8\frac{1}{2}^{o}$ to the horizontal. This groove 6 locates a plunger 8 which is movable vertically in a circular bore 9 in the slide 2. The upper part of the plunger 8 is of circular cross-section which has a diameter approximately 25 μm smaller than that of the bore 9. The lower part of the plunger 8 has a rectangular cross-section, and two opposite sides 10, 11 of this lower part of the plunger 8 co-operate with respective sides 12, 13 of the groove 6 so as to maintain a bevelled portion 14 of the bottom of the plunger 8 substantially parallel to and facing the ramp 7 during movement of the slide 2. A minor part 15 of the bottom of the plunger 8 is parallel to the top of the plunger 8, and serves to reduce wear on the side surfaces of the plunger 8 when the slide 2 is moved. The bevelled surface 14 on the bottom of the plunger 8 co-operates with the ramp 7 to lift the plunger 8 in the bore 9.

Referring to Figure 3, the slide 2 is provided with a recess 16 which serves as a holder for a substrate 17 (Figure 2) on which a layer of material is to be grown by liquid phase epitaxy. A cross-member 18 is provided on top of the right hand end of the slide 2 and serves as a stop which limits the travel of the slide 2 under the well member 5.   A recess 19 in the upper part of the cross-member 18 accommodates a head 20 (Figure 2) of an operating rod 21 used to move the slide 2, which operating rod 21 is manipulated from outside a furnace (not shown) in which the apparatus is used.

Referring to Figure 2, the well member 5 is provided with a well 22 which is of a circular cross-section that is smaller than the cross-section of the recess 16 in the slide 2.   The bottom surface of the well member 5 is provided on the slide-withdrawal side of the well 22 with a number of transverse grooves 23.   These grooves 23 extend across the width of the well member 5 and have a square cross-section of 3 mm side, this groove size being chosen for ease of satisfactory milling in graphite.   The top of the well 22 is closed by a lid 24.   An end stop 25 on the base 1 limits the movement of the slide 2 away from the well member 5.     A longitudinal bore 26 in the base 1 ends below the well 22 and houses a thermocouple 27 which is used to measure the growth temperature.

In order to grow an epitaxial layer on a substrate, the substrate 17 (which has been polished) was placed in the recess 16 in the slide 2.   The slide 2 was moved so that the substrate was situated to the left of the well 22.   A solid charge consisting of a growth solution was then placed in the well 22, the lid 24 was placed in the well 22, and the apparatus was placed in a tubular furnace (not shown).   A protective atmosphere was introduced into the furnace, and the apparatus was heated to a temperature 5 Celsius degrees above the growth temperature.   The temperature was then lowered to the growth temperature, at which point the slide 2 was moved so that the substrate 17 was positioned under the well 22, and growth of an epitaxial layer from solution 28 in the well 22 began.   The temperature of the apparatus was progressively lowered and growth was terminated by moving the slide 2 to the right.   At the end of the growth process the top face of the epitaxial layer was $10\mu m$ below the top surface of the slide 2.

Until the bevelled portion 14 of the plunger 8 engaged with the ramp 7, the top of the plunger 8 was 1 mm below the bottom of the substrate 17. When the slide 2 was moved to the right, solution 28 which had been wiped-off the surface of the epitaxial layer and would otherwise have sprung back onto the epitaxial layer was wiped into and retained in the grooves 23. The slide 2 was moved further to the right and during this movement the plunger 8 was raised in the bore 9, first abutting the underside of the substrate 17 and then lifting the substrate out of the recess 16. This prevented the substrate 17 from being frozen into the recess 16 due to solidification of small quantities of growth solution 28 which had flowed between the edges of the substrate 17 and the side-walls of the recess 16.

EXAMPLE 2

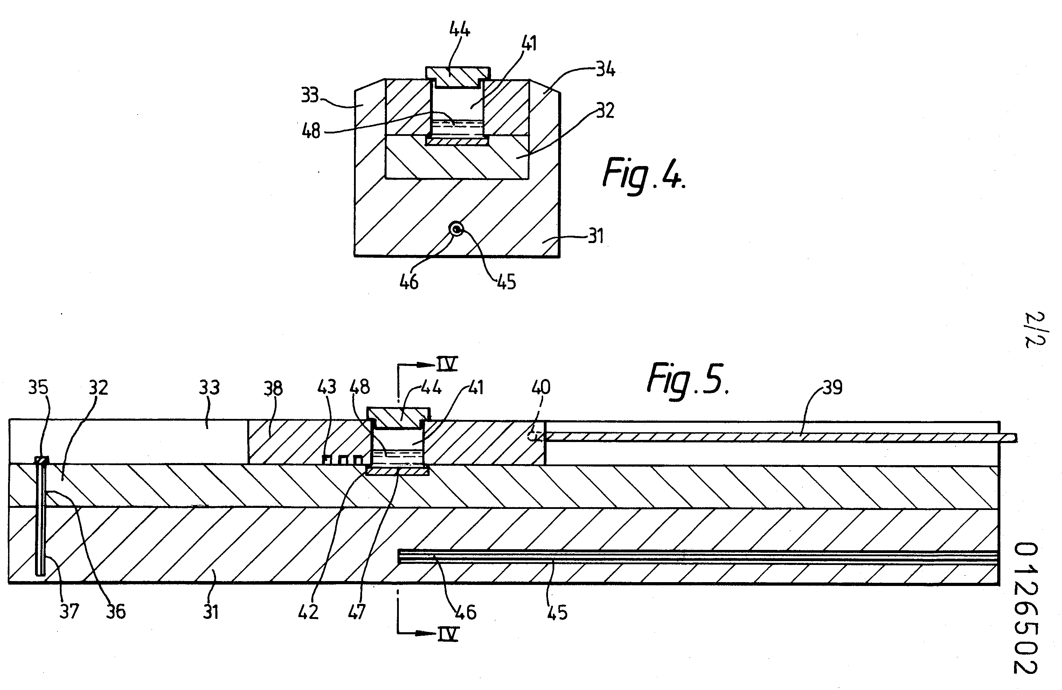

Figures 4 and 5 show another sliding boat liquid phase epitaxy apparatus. This apparatus comprises a graphite base 31 in which a vitreous silica substrate support 32 is located by means of side walls 33 and 34 of the base 31. A graphite pin 35 passes through a bore 36 in the substrate support 32 and extends into a closed bore 37 extending from the top surface of the base member 31, thereby preventing movement of the substrate 32 with respect to the base 31. A graphite well member 38 is superposed on the substrate support 32, is located between the sidewalls 33 and 34 of the base 31, and can be moved in the length direction of the apparatus by means of an operating rod 39 having a head 40 which is located in a recess near the right hand end (in Figure 5) of the well member 38.

The well member 38 is provided with a well 41 which is of a circular cross-section that is smaller than the cross-section of a substrate holder recess 42 in the substrate support 32. The bottom surface of the well member 38 is provided on the leftward side in Figure 5 of the well 41 with a number of transverse grooves 43 which extend across the width of the well member 38. These grooves 43 have a square cross-section of 3mm side, this groove size being chosen for ease of satisfactory milling in graphite. The top of the well 38 is closed by a lid 44. A longitudinal bore 45 in the base 31 ends below the well 42 and houses a thermocouple 46 which is used to measure the growth temperature.

An epitaxial layer was grown on a polished substrate 47 which had been placed in the substrate holder recess 42 from a growth solution 48 contained in the well 41 by a method similar to that described in Example 1. Growth of the epitaxial layer was terminated by moving the well member 38 to the right (in Figure 5) so that the grooves 43 traversed the epitaxial layer.

This apparatus is suitable for use with a growth solution, for example, a solution of a II-VI compound in tellurium, which wets graphite but which does not wet vitreous silica. Since the substrate holder is not wetted by the growth solution, the problem does not arise of the substrate being inextricably bonded to the substrate support.

In the embodiments described, the well member has only a single well. An apparatus according to the invention may be used in multiple-well liquid phase epitaxy, for example in the growth of double heterojunction injection laser structures. Such a structure may be grown on an n-type GaAs substrate and consist of an n-type $Al_xGa_{1-x}As$ layer, a p-type GaAs layer, a p-type $Al_xGa_{1-x}As$ layer and a p-type GaAs layer. When such a structure is grown, a group of substantially transverse grooves are provided in the bottom surface of the well member adjacent each well. When an apparatus as described in Example 1 is provided with means for lifting the substrate out of the substrate holder, the substrate is only lifted out of the substrate holder after the growth of the last epitaxial layer has been completed.

CLAIMS:

1. A sliding boat liquid phase epitaxy apparatus comprising a base, substrate support means superposed on the base, and a well member abutting and disposed above the substrate support means and having at least one well capable of containing growth solution, the substrate support means comprising a recessed substrate holder which can be disposed under the/each well, wherein the well member and the substrate support means are relatively slidable in the length direction of the apparatus, wherein the bottom of the well member is provided with a plurality of grooves on the side of the/each well which traverses or is traversed by the recessed substrate holder after growth of an epitaxial layer, and wherein the grooves extend across at least a width of the well member which is greater than and includes the width of the substrate holder recess.

2. A sliding boat liquid phase epitaxy apparatus as claimed in Claim 1, wherein the grooves are straight.

3. A sliding boat liquid phase epitaxy apparatus as claimed in Claim 1 or Claim 2, wherein the well member is fixed in a horizontal sense with respect to the base member, and the substrate support means are a slide restricted in operation to longitudinal movement in the apparatus and having a recessed substrate holder.

4. A sliding boat liquid phase epitaxy apparatus as claimed in Claim 3, wherein the well member is held rigidly in a vertical direction with respect to the base member.

5. A sliding boat liquid phase epitaxy apparatus as claimed in Claim 4, having means for lifting a substrate out of the substrate holder, the means comprising a plunger which is slidable in a bore extending from the bottom of the slide into the substrate holder, the bottom of the plunger being at least partly bevelled, further means for maintaining this bevelled surface substantially parallel to a ramp formed in the upper surface of the base, wherein the bevelled surface of the plunger co-operates with the ramp so as to lift the plunger so that it abuts and then lifts a substrate disposed in the substrate holder out of the substrate holder after the completion of epitaxial growth and before growth solution in contact with the substrate holder has frozen.

6. A sliding boat liquid phase epitaxy apparatus as claimed in Claim 5, wherein the ramp is at one end of a groove extending longitudinally in the upper surface of the base.

7. A sliding boat liquid phase epitaxy apparatus as claimed in Claim 5, wherein the further means consist of non-circular co-operating cross-sections of the plunger and of the bore.

8. A sliding boat liquid phase epitaxy apparatus as claimed in Claim 5, wherein the further means comprise faces on opposite sides of a lower portion of the plunger which are parallel to the longitudinal axis of the apparatus and which co-operate with the sides of the groove in the base.

9. A sliding boat liquid phase epitaxy apparatus as claimed in Claim 1 or Claim 2, wherein the substrate support means are fixed in a horizontal sense with respect to the base, and the well member is slidable over the substrate support means in the length direction of the apparatus.

10. A sliding boat liquid phase epitaxy apparatus as claimed in any preceding Claim, wherein the area of the/each well is smaller than the area of the substrate holder recess.

Fig.1.

Fig.2.

Fig.3.

1-II-PHB32973

0126502

0126502

Fig.4.

Fig.5.

2-II PHB32973